# EUROPEAN PATENT APPLICATION

(11) **EP 4 625 502 A1**
(43) Date of publication of application: **01.10.2025**
(21) Application number: 23894408.6
(22) Date of filing: 07.11.2023
(51) Int. Cl.: H01L 33/16, G09F 9/33, H01L 33/30

(54) **MICRO-LED STRUCTURAL BODY AND MANUFACTURING METHOD FOR SAME**

(30) Priority: 24.11.2022 JP 2022187735
(71) Applicant: Shin-Etsu Handotai Co., Ltd., Tokyo 100-0004 (JP)
(72) Inventor: ISHIZAKI Junya, Annaka-shi, Gunma 379-0196 (JP)
(74) Representative: Röthinger, Rainer
(86) International application number: PCT/JP2023/039960
(87) International publication number: WO 2024/111396

(57) **Abstract**

The present invention is a micro-LED structure including a light emitting device structure having an active layer composed of (Al_{y}Ga_{1-y})ₓIn₁₋ₓP (0.4≤x≤0.6, 0≤y≤0.5), the light emitting device structure being bonded to a transparent substrate transparent to both an emission wavelength and a laser light for LLO transfer by an adhesive that is transparent to the emission wavelength and absorbs the laser light for LLO transfer or a bonding material that is transparent to the emission wavelength and absorbs the laser light for LLO transfer, in which the light emitting device structure is device isolated, the light emitting device structure, which is device isolated, has at least two electrodes of different polarities on one surface, and a long-side direction of an outer shape of the light emitting device structure, which is device isolated, in a plan view does not align with a crystal orientation of <110>. This provides the micro-LED structure in which cracking of the micro-LED structure can be reduced or avoided when transfer is performed in the LLO step in the micro-LED structure in which a light emitting device structure having an AlGaInP-based active layer is bonded to a transparent substrate via the adhesive or the bonding material.

## Description

### TECHNICAL FIELD

The present invention relates to a micro-LED structure and a method for producing the same.

### BACKGROUND ART

In order to realize micro light emitting diode displays (micro-LED displays), a technique has been disclosed, where LEDs are separated from starting substrates using laser lift-off (LLO) and transferred to substrates for mounting, followed by transfer to drive substrates (Patent Document 1). However, all of these techniques are for GaN-based LEDs, and technical disclosures regarding micro-LEDs (µ-LEDs) using AlGaInP-based LEDs are few.

To realize micro-LED devices using the AlGaInP-based LEDs through a LLO step, it is required to transfer the LEDs to substrates transparent to laser for LLO, such as sapphire substrates. Regarding a technique for transferring AlGaInP-based LEDs to sapphire substrates, prior art has been disclosed in Patent Document 2 or the like.

### CITATION LIST

### PATENT LITERATURE

Patent Document 1: JP 2020-521181 A
Patent Document 2: JP 2022-013203 A
Patent Document 3: JP 2016-004892 A
Patent Document 4: JP 2007-242804 A
Patent Document 5: JP 2015-084448 A

### SUMMARY OF INVENTION

### TECHNICAL PROBLEM

However, an AlGaInP-based LED has problems of being mechanically fragile compared to a GaN-based LED and a die cracking is prone to generate in the LLO step depending on the suitability of die design. No technical disclosure has been provided regarding an avoidance of micro-LED structure cracking (also referred to as "µ-LED die cracking") during the LLO step.

Furthermore, the micro-LED has a thin thickness, resulting in vulnerability to stress compared to a conventional LED. According to the study by the present inventor, it is found that due to such a low strength, when devices are pressed against a transfer substrate during the LLO step, stress is applied to a step portion that is provided in the devices for attaching electrodes of different polarities, and that when a direction relative to the step, in which the step extends in a plan view, is substantially the same as a crystal orientation of <110>, the devices are highly prone to cracking due to cleavability of the crystal.

Note that Patent Document 3 discloses a technique for prevention of chipping during the dicing step when forming dice for conventional-sized LEDs rather than such a die cracking during a transfer of micro-LEDs. In this Patent Document 3, a technique is disclosed for dicing with shifting a predetermined dicing line from a crystal orientation of <110> during dicing of conventional-sized LEDs. However, Patent Document 3 is the technical disclosure regarding a measure for chipping during dicing processing of the conventional-sized LEDs, not for the die cracking when transferring the micro-LEDs in the LLO step.

Moreover, Patent Document 4 discloses the prior art to provide an angle to dice. This is the technique of providing the angle to a growth direction but not for die cracking when transferring micro-LEDs in the LLO step.

Patent Document 5 discloses a technique to arrange a device functional portion that is shifted away from a crystal orientation of <110>, independently of a base portion of devices. However, Patent Document 5 is not for die cracking when transferring micro-LEDs in the LLO step.

In view of the above, no technical disclosure has been made regarding the avoidance of the micro-LED die cracking during the LLO step.

The present invention has been made in view of the above-described problem. An object of the present invention is to provide a micro-LED structure in which cracking of the micro-LED structure can be reduced or avoided when transfer is performed in the LLO step. This micro-LED structure includes a light emitting device structure having an AlGaInP-based active layer bonded to a transparent substrate via an adhesive or a bonding material. The object is also to provide a method for producing such a micro-LED structure.

### SOLUTION TO PROBLEM

To achieve the object, the present invention provides a micro-LED structure comprising a light emitting device structure having an active layer composed of (Al_{y}Ga_{1-y})ₓIn₁₋ₓP (0.4≤x≤0.6, 0≤y≤0.5), the light emitting device structure being bonded to a transparent substrate transparent to both an emission wavelength and a laser light for LLO transfer by an adhesive that is transparent to the emission wavelength and absorbs the laser light for LLO transfer or a bonding material that is transparent to the emission wavelength and absorbs the laser light for LLO transfer, wherein
the light emitting device structure is device isolated,
the light emitting device structure, which is device isolated, has at least two electrodes of different polarities on one surface, and
a long-side direction of an outer shape of the light emitting device structure, which is device isolated, in a plan view does not align with a crystal orientation of <110>.

In general, the micro-LED structure having an AlGaInP-based active layer has a low mechanical strength; however, the inventive micro-LED structure described above can prevent a portion having a particularly weak mechanical strength from becoming prone to cracking due to cleavability of a crystal. As a result, the cracking (die cracking, damage) of the micro-LED structure can be reduced or avoided when transferring the micro-LED structure in the LLO step.

In this case, it is preferable that the long-side direction of the outer shape of the light emitting device structure in the plan view is shifted in a range of 10° or more and 45° or less from the crystal orientation of <110>.

Furthermore, in this case, it is preferable that the long-side direction of the outer shape of the light emitting device structure in the plan view is shifted in a range of 22.5° or more and 30° or less from the crystal orientation of <110>.

With such angles, the long-side direction of the outer shape of the light emitting device structure in the plan view can be set to not only the crystal orientation of <110> but also to a distant angle from an orientation of <100> where prone to cracking, thereby more effectively reducing and improving the rate of micro-LED structure cracking (die cracking, damage) generation in the LLO step.

Moreover, in the inventive micro-LED structure, it is preferable that the light emitting device structure does not have a starting substrate.

In this way, by having the light emitting device structure without the starting substrate, the transfer to a desired transfer substrate is enabled.

Moreover, it is preferable that the adhesive or the bonding material is benzocyclobutene.

In this way, by using benzocyclobutene as the adhesive or the bonding material, LLO treatment can be reliably performed by an excimer laser.

Moreover, it is preferable that the transparent substrate is sapphire or quartz.

These substrates can be suitably used as the transparent substrate. In particular, the substrate having a high transmittance to laser for LLO can be selected.

Moreover, the present invention provides a method for producing a micro-LED structure, the method comprising the steps of:
forming a light emitting device structure having an active layer composed of (Al_{y}Ga_{1-y})ₓIn₁₋ₓP (0.4≤x≤0.6, 0≤y≤0.5) on a starting substrate;
bonding the light emitting device structure to a transparent substrate transparent to an emission wavelength of the light emitting device structure by an adhesive or a bonding material;
device isolating the light emitting device structure; and
forming at least two electrodes of different polarities on one surface of the light emitting device structure, which is device isolated, wherein
in the step of device isolating, a long-side direction of an outer shape of the light emitting device structure, which is device isolated, in a plan view does not align with a crystal orientation of <110>.

With such a method for producing a micro-LED structure, it is possible to prevent a portion having a weak structural strength of the produced micro-LED structure from becoming prone to cracking due to the cleavability of a crystal. As a result, the cracking (damage) of the micro-LED structure can be reduced or avoided when transferring the micro-LED structure in the LLO step.

In this case, it is preferable that the long-side direction of the outer shape of the light emitting device structure in the plan view is shifted in a range of 10° or more and 45° or less from the crystal orientation of <110>.

Furthermore, in this case, it is possible that the long-side direction of the outer shape of the light emitting device structure in the plan view is shifted in a range of 22.5° or more and 30° or less from the crystal orientation of <110>.

By performing device isolation at such angles to shift the long-side direction of the outer shape of the light emitting device structure in the plan view from the crystal orientation of <110>, the occurrence rate of die cracking during the LLO step can be more effectively reduced and improved.

Moreover, in the inventive method for producing a micro-LED structure, it is preferable that the method further comprises the step of removing the starting substrate.

In this way, by removing the starting substrate, the transfer to a desired transfer substrate is enabled.

Moreover, it is preferable that the adhesive or the bonding material is benzocyclobutene.

In this way, by using benzocyclobutene as the adhesive or the bonding material, LLO treatment can be reliably performed by an excimer laser.

Moreover, it is preferable that the transparent substrate is sapphire or quartz.

These substrates can be suitably used as the transparent substrate. In particular, the substrate having a high transmittance to laser for LLO can be selected.

### ADVANTAGEOUS EFFECTS OF INVENTION

In general, the micro-LED structure having the AlGaInP-based active layer has low mechanical strength. In contrast, the inventive micro-LED structure can prevent a portion having a weak structural strength from becoming prone to cracking due to the cleavability of a crystal. Therefore, according to the present invention, the cracking (die cracking, damage) of the micro-LED structure can be reduced or avoided when transferring the micro-LED structure in the LLO step. Moreover, the inventive method for producing a micro-LED structure enables the production of such a micro-LED structure.

### BRIEF DESCRIPTION OF DRAWINGS

FIG. 1 is a schematic view illustrating an example (first embodiment) in a plan view of a micro-LED structure according to the present invention.
FIG. 2 is a schematic view illustrating another example (second embodiment) in a plan view of a micro-LED structure according to the present invention.
FIG. 3 is a schematic view illustrating even another example (third embodiment) in a plan view of a micro-LED structure according to the present invention.
FIG. 4 is a schematic view illustrating even another example (fourth embodiment) in a plan view of a micro-LED structure according to the present invention.
FIG. 5 is a schematic cross-sectional view illustrating a part of a method for producing a micro-LED structure according to the present invention.
FIG. 6 is a schematic cross-sectional view illustrating another part of a method for producing a micro-LED structure according to the present invention.
FIG. 7 is a schematic cross-sectional view illustrating another part of a method for producing a micro-LED structure according to the present invention.
FIG. 8 is a schematic cross-sectional view illustrating another part of a method for producing a micro-LED structure according to the present invention.
FIG. 9 is a schematic cross-sectional view illustrating another part of a method for producing a micro-LED structure according to the present invention.
FIG. 10 is a schematic cross-sectional view illustrating another part of a method for producing a micro-LED structure according to the present invention.
FIG. 11 is a schematic cross-sectional view illustrating a part of a method in which a micro-LED structure of the present invention is produced and then transferred to a transfer substrate.
FIG. 12 is a graph showing results in Examples and Comparative Example.

### DESCRIPTION OF EMBODIMENTS

The inventive micro-LED structure is a micro-LED structure comprising a light emitting device structure having an active layer composed of (Al_{y}Ga_{1-y})ₓIn₁₋ₓP (0.4≤x≤0.6, 0≤y≤0.5), the light emitting device structure being bonded to a transparent substrate transparent to both an emission wavelength and a laser light for LLO transfer by an adhesive that is transparent to the emission wavelength and absorbs the laser light for LLO transfer or a bonding material that is transparent to the emission wavelength and absorbs the laser light for LLO transfer, wherein
the light emitting device structure is device isolated,
the light emitting device structure, which is device isolated, has at least two electrodes of different polarities on one surface, and
a long-side direction of an outer shape of the light emitting device structure, which is device isolated, in a plan view does not align with a crystal orientation of <110>.

This micro-LED structure can be the structure in which one side does not exceed 100 µm.

Hereinafter, the present invention will be described in detail with reference to the drawings. However, the present invention is not limited thereto. In the following, the embodiments of the present invention will be described, exemplifying from the first embodiment to the fourth embodiment. Similar elements in each embodiment will be described using the same reference signs.

### (First Embodiment)

First, the first embodiment is described. This first embodiment is a case in which an outer shape of a micro-LED structure in a plan view is a square shape.

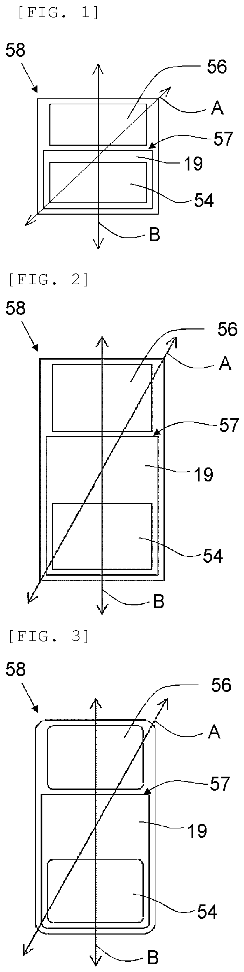

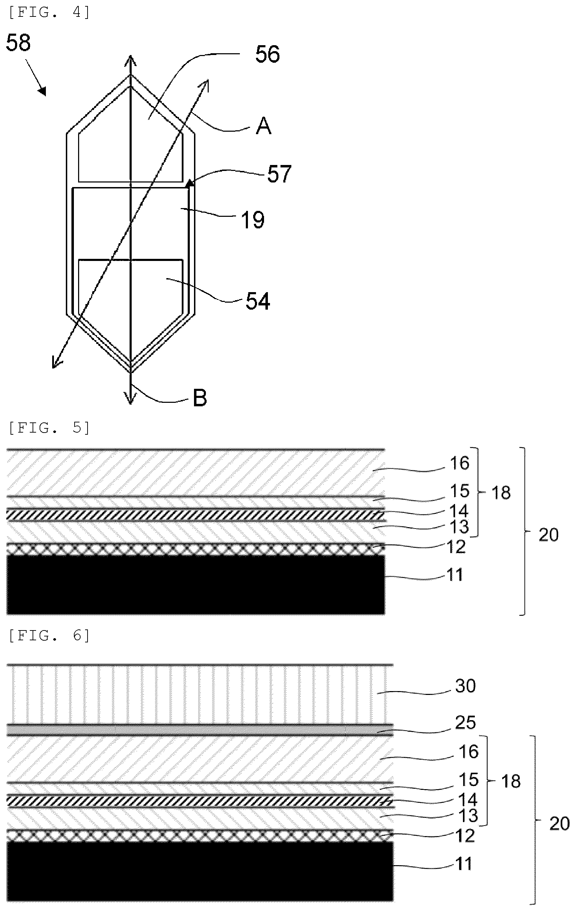

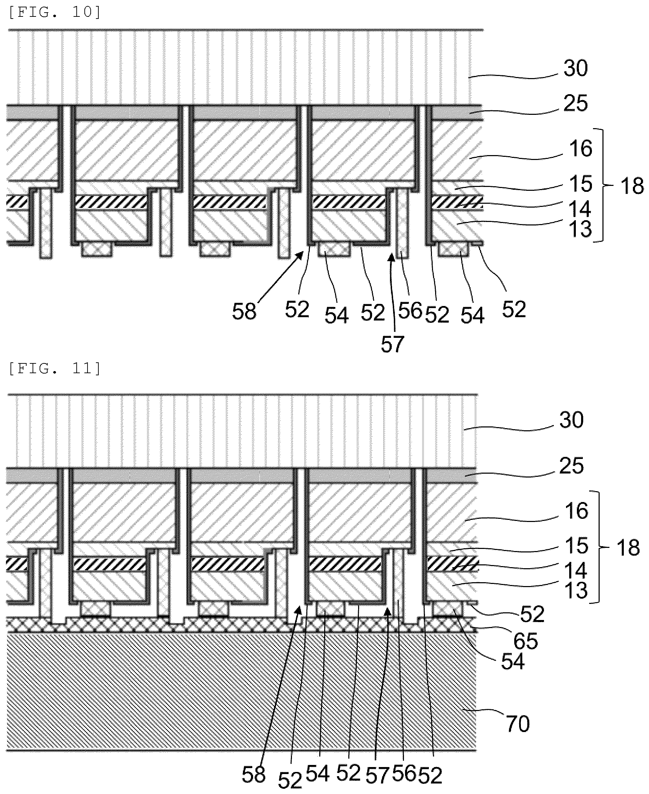

The inventive micro-LED structure can be produced, for example, through the steps (FIGS. 5 to 10) described later. Among these, the inventive micro-LED structure is described, referring to FIG. 10 and referring to FIG. 1.

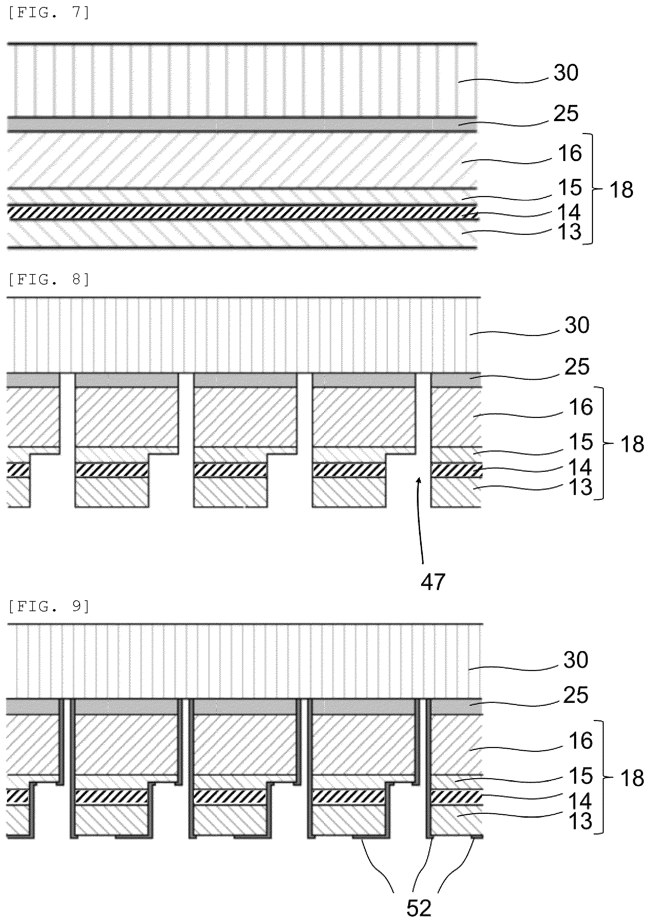

As shown in FIG. 10, which is a schematic cross-sectional view, the inventive micro-LED structure 58 includes a light emitting device structure 18 having an active layer 14 composed of (Al_{y}Ga_{1-y})ₓIn₁₋ₓP (0.4≤x≤0.6, 0≤y≤0.5). Moreover, the light emitting device structure 18 is bonded to a transparent substrate 30 transparent to both an emission wavelength and a laser light for LLO transfer by an adhesive that is transparent to the emission wavelength and absorbs the laser light for LLO transfer or a bonding material 25 that is transparent to the emission wavelength and absorbs the laser light for LLO transfer. Furthermore, the light emitting device structure 18 is device isolated by a device isolation groove (device isolation groove 47 formed in FIG. 8 described later). The light emitting device structure 18, which is device isolated, has at least two electrodes 54 and 56 of different polarities on one surface. In addition, as shown in FIG. 1, which is a schematic view in a plan view, a long-side direction B of an outer shape of the light emitting device structure 18, which is device isolated, in a plan view does not align with a direction A of a crystal orientation of <110>.

In the present invention, as described above, a positional relationship (angular relationship) between the long-side direction of the outer shape of the light emitting device structure, which is device isolated, in the plan view and a direction of the crystal orientation of <110> is defined. This long side of the outer shape refers to the longest side. The first embodiment is the case in which the outer shape of the micro-LED structure in the plan view is square. FIG. 1 shows the micro-LED structure 58, including the light emitting device structure 18 being device isolated in the square shape. The long sides (the longest sides) of the square are in two directions that are perpendicular to each other, and for both long sides, the direction of crystal orientation of <110> is shifted.

FIG. 1 shows a first electrode 54 as an upper electrode and a second electrode 56 as a lower electrode, as two electrodes 54 and 56 of different polarities. A light-emitting layer region 19 shown in FIG. 1 shows a region including the active layer 14 in a plan view. As can be seen from a comparison between FIGS. 1 and 10, the first electrode 54 is positioned on a layer 13. Moreover, the second electrode is positioned on a layer 15. As described later, since the layer 13 is a first conductivity-type and the layer 15 and a layer 16 are a second conductivity-type in FIG. 10, a step portion 57 is provided to attach the electrodes of different polarities on each layer. Stress is applied to this step portion 57 when devices are pressed against a transfer substrate during the LLO step. When a direction along the step portion 57 aligns with the crystal orientation of <110>, the steps are highly prone to cracking due to the cleavability of the crystal. On the other hand, in the present invention, the step portion 57 has high strength and thus can be made difficult to crack. An AlGaInP-based LED is mechanically fragile compared to a GaN-based LED, and die cracking is prone to generate during the LLO step depending on the suitability of die design. Consequently, an effect of suppressing the die cracking according to the present invention is significant.

In this case, it is preferable that the long-side direction of the outer shape of the light emitting device structure 18 in the plan view is shifted in a range of 10° or more and 45° or less from the crystal orientation of <110> (direction A). In addition, it is possible that the long-side direction of the outer shape of the light emitting device structure 18 in the plan view is shifted in a range of 22.5° or more and 30° or less from the crystal orientation of <110> (direction A).

Furthermore, as shown in FIG. 10, it is preferable that the inventive micro-LED structure 58 includes the light emitting device structure 18 that does not have a starting substrate. By configuring the micro-LED structure 58 that does not have the starting substrate, the transfer thereof to a desired substrate is enabled. The light emitting device structure 18 without the starting substrate can be achieved by removing a starting substrate 11 (see FIGS. 6 and 7), as described later.

Moreover, in the inventive micro-LED structure 58, it is preferable that the adhesive or the bonding material 25 is benzocyclobutene (BCB). By using benzocyclobutene as the adhesive or the bonding material, LLO treatment can be reliably performed by an excimer laser.

Moreover, in the inventive micro-LED structure 58, it is preferable that the transparent substrate 30 is sapphire or quartz. These substrates can be suitably used as the transparent substrate. In particular, the substrate having a high transmittance to laser for LLO can be selected.

Next, such a method for producing a micro-LED structure is described. In the first embodiment, a case is described in which the micro-LED structure 58 having the outer shape in the plan view in FIG. 1 is produced.

First, a light emitting device structure having an active layer composed of (Al_{y}Ga_{1-y})ₓIn₁₋ₓP (0.4≤x≤0.6, 0≤y≤0.5) is formed. Accordingly, as shown in FIG. 5, epitaxial growth is performed sequentially on the starting substrate 11 to form each layer and produce an epitaxial wafer 20. Consequently, an epitaxial layer having an etching stop layer 12 and the light emitting device structure 18 is produced. More specifically, the epitaxial growth of each layer can be performed as follows.

In this step, first, as shown in FIG. 5, an etching stop layer 12 is epitaxially grown on a first conductivity-type GaAs substrate 11, being the starting substrate. The etching stop layer 12 can be formed, for example, after laminating a first conductivity-type GaAs buffer layer, followed by growing a first conductivity-type GaₓIn₁₋ₓP (0.4≤x≤0.6) first etching stop layer having a thickness of, e.g., 0.1 µm, and a first conductivity-type GaAs second etching stop layer having a thickness of, e.g., 0.1 µm. Moreover, the epitaxial wafer 20 is provided with the light emitting device structure 18 as an epitaxial functional layer, in which, for example, a first conductivity-type (Al_{y}Ga_{1-y})ₓIn₁₋ₓP (0.4≤x≤0.6, 0.6≤y≤1.0) first cladding layer 13 having a thickness of, e.g., 1.0 µm, a non-doped (Al_{y}Ga_{1-y})ₓIn₁₋ₓP (0.4≤x≤0.6, 0≤y≤0.5) active layer 14, a second conductivity-type (Al_{y}Ga_{1-y})ₓIn₁₋ₓP (0.4≤x≤0.6, 0.6≤y≤1.0) second cladding layer 15 having a thickness of, e.g., 1.0 µm, a second conductivity-type GaₓIn₁₋ₓP (0.5≤x≤1.0) intermediate layer (not shown) having a thickness of, e.g., 0.1 µm, and a second conductivity-type GaP window layer 16 are sequentially grown on the etching stop layer 12. At this point, from the first cladding layer 13 to the second cladding layer 15 is referred to as a double-hetero (DH) structure part (FIG. 5).

The film thicknesses exemplified above are just examples, and the film thickness is no more than a parameter to be changed according to the operating specifications of the device; therefore, it is needless to say that the film thickness is not limited to the thickness described here. The case where both the first cladding layer 13 and the second cladding layer 15 have a thickness of 1.0 µm is exemplified, but rated current density of the micro-LED is smaller than that of a discrete LED with a larger size, and even with a thinner film thickness, a function as the cladding layer is not compromised.

As described later, the electrodes are formed as being in contact with the first cladding layer 13, thus, it is suitable that the first cladding layer 13 has a thickness of 0.6 µm or more, considering metal diffusion during ohmic contact formation. When the thickness is greater than this, any greater thickness can be selected. However, it is preferable to design the first cladding layer 13 to be 10 µm or less. Such a thickness does not cause a factor for increasing cost in a great degree, can ensure luminous efficiency during constant current driving, and can obtain a high yield by suppressing wafer warp.

When the second conductivity-type is P-type, an effective mass of a hole is large, allowing the second cladding layer 15 to have a thickness of, for example, about 0.2 µm to function in the same way as in a thickness of 1.0 µm. Therefore, a thickness of 0.2 µm or more is preferable, and any greater thickness can be selected. However, it is preferable to design the second cladding layer 15 to be 10 µm or less. Such a thickness does not cause a factor for increasing cost in a great degree, can ensure luminous efficiency during constant current driving, and can obtain a high yield by suppressing wafer warp.

Moreover, it is needless to say that a concept includes that each layer is not a single composition layer but has a layer of a plurality of compositions within a range of compositions shown in the example. Furthermore, it is needless to say that a concept includes that levels of carrier concentrations are not uniform in each layer, but the concentrations have a plurality of levels in each layer.

The active layer 14 may be composed of a single composition or may have a super-lattice structure where a plurality of barrier layers and active layers are alternatively stacked. Both have the same function, and any one of the cases can be selected. The operation and effect of this technique are the same regardless of which structure is selected.

Moreover, it is preferable that the GaP window layer 16 has a thickness of larger than 5 µm; for example, the thickness can be 6 µm. However, the thickness is not limited to 6 µm; for example, any thickness can be selected as long as the thickness is within a thickness range that is thinner than a short side length at device isolation.

Next, as shown in FIG. 6, the light emitting device structure 18 is bonded to the transparent substrate 30 transparent to both the emission wavelength of the light emitting device structure and the laser light for LLO transfer by the adhesive that is transparent to the emission wavelength and absorbs the laser light for LLO transfer or the bonding material 25 that is transparent to the emission wavelength and absorbs the laser light for LLO transfer. For example, benzocyclobutene (BCB), being a thermosetting bonding member, is spin-coated as the adhesive or the bonding material 25 on the epitaxial wafer 20. The transparent substrate 30, such as a sapphire wafer, is then stacked facing each other and bonded by thermocompression in a vacuum atmosphere. When BCB is coated by spin coating, a thickness can be, for example, 0.6 µm.

Note that the atmosphere for thermocompression is not limited to the vacuum atmosphere; however, any atmosphere can be adopted as long as the atmosphere has an oxygen content of 100 ppm or less. For example, the same effect can be obtained in a nitrogen atmosphere or an argon atmosphere.

Moreover, the transparent substrate 30 is not limited to the sapphire, and any material can be selected as long as laser light transmittance and flatness are guaranteed. Quartz can be selected instead of sapphire.

Moreover, when BCB is used as the adhesive or the bonding material 25, the same result can be obtained not only by applying BCB in a layered shape but also by patterning into an isolated island shape, a line shape, or other shapes using photosensitive BCB and performing the bonding step.

In addition, the thickness of the adhesive or the bonding material 25, such as BCB, is not limited to 0.6 µm and may be thinner than this thickness.

Then, as shown in FIG. 7, it is preferable to remove the starting substrate 11 (for example, GaAs starting substrate) by wet etching. Moreover, the etching stop layer 12 is subsequently also removed. When removing the etching stop layer 12 that includes the first etching stop layer and the second etching stop layer as described above, the first etching stop layer can be exposed first by etching, then an etchant is switched to remove the second etching stop layer and the epitaxial layer (the first cladding layer 13 in the light emitting device structure 18) can be exposed. In this way, the bonded wafer that retains only the double-hetero (DH) structure part (first cladding layer 13, active layer 14, and second cladding layer 15) and the window layer 16 can be produced (FIG. 7).

Next, as shown in FIG. 8, the light emitting device structure 18 is device isolated. In this case, the long-side direction B of the outer shape of the light emitting device structure 18, which is device isolated, in the plan view is made not to align with the direction A of the crystal orientation of <110> (see FIG. 1). Specifically, this device isolation can be performed in the following way, but is not limited to this as long as the device isolation can be performed.

First, a SiO₂ film having a thickness of 1 µm is formed on an epitaxial bonded wafer (i.e., on the first cladding layer 13) using a P-CVD method (plasma CVD method) using TEOS (tetraethoxysilane) and O₂ as raw materials.

Next, a resist pattern is formed using a photolithography method, and a pattern shape of SiO₂ is produced using wet etching with a hydrofluoric acid solution. Subsequently, ICP (inductively coupled plasma) processing is performed in an ICP apparatus in which chlorine-based gas is introduced using the SiO₂ pattern as a hard mask, and the DH structure part (from the first cladding layer 13 to the second cladding layer 15) and the GaP window layer 16 are dry etched to expose the adhesive or the bonding material 25 such as the BCB layer. Then, the etching gas is switched, and the exposed adhesive or bonding material is further dry etched to expose a sapphire substrate, thereby forming an island-shaped pattern composed of the DH structure part (from the first cladding layer 13 to the second cladding layer 15) and the GaP window layer 16. The island-shaped pattern here is substantially the same as the SiO₂ pattern described above.

The SiO₂ pattern shape, that is, the shape that forms the outer shape (island-shaped pattern described above) of light emitting device structure in the plan view, after the device isolation, preferably has a side length of less than 100 µm. In this embodiment, the shape thereof is substantially square. In this embodiment, it is preferable that this substantially square-shaped pattern is formed in such a way that a line connecting a corner point and an opposite corner point is substantially the same as the direction of crystal orientation of <110> (see FIG. 1).

In this way, the line connecting the corner point and the opposite angle in the SiO₂ pattern (that is, the shape that forms the outer shape of light emitting device structure in the plan view after the device isolation) can be formed to be substantially the same as the direction of crystal orientation of <110> (direction A). However, it is needless to say that the same effect can be obtained even when a directional alignment to the crystal orientation of <110> is not exactly aligned. It is essential that the side of the SiO₂ pattern is not substantially the same as the direction of crystal orientation of <110>, and this effect can be more reliably obtained by shifting a direction of the side by 10° or more from the crystal orientation of <110>. An angle between the line connecting diagonal lines and the crystal orientation of <110> is maximally 45°, therefore, the maximum angle is 45°. That is, as shown in FIG. 1, it is preferable that the long-side direction B of the outer shape of the light emitting device structure 18, which is device isolated, in the plan view is shifted in a range of 10° or more and 45° or less from the direction A of the crystal orientation of <110>. Moreover, in particular, it is possible that the long-side direction of the outer shape of the light emitting device structure 58, which is device isolated, in the plan view is shifted in a range of 22.5° or more and 30° or less from the direction A of the crystal orientation of <110>.

Next, as shown in FIG. 8, the step portion for electrode formation is provided in each light emitting device structure, which is device isolated. Specifically, after forming the island-shaped pattern described above, a part of the double-hetero (DH) structure part (first cladding layer 13, active layer 14, and second cladding layer 15) is etched using the ICP method in the same way described above to expose the second cladding layer 15 or the window layer 16.

After the device isolation processing (and exposure of the second cladding layer 15 or the GaP window layer 16) shown in FIG. 8, a protective film 52 can be formed on a processed cross section as end face processing as shown in FIG. 9. Here, for example, a SiO₂ protective film can be formed as the protective film 52 using the same P-CVD method described above. In addition, the protective film 52 is not limited to SiO₂, and any material that can protect the end face and has insulating properties can be selected. SiNx, titanium oxide, or magnesium oxide or the like can be selected.

Subsequently, as shown in FIG. 10, at least two electrodes of different polarities are formed on one surface of the light emitting device structure, which is device isolated. The "one side" here can be a side opposite to a side bonded to the transparent substrate 30 by the adhesive or the bonding material 25. Here, the first electrode 54, which is in contact with the first cladding layer 13, and the second electrode 56, which is in contact with the second cladding layer 15 or the GaP window layer 16, are formed to produce the micro-LED structure 58 (also referred to as "µ-LED dice").

When the first conductivity-type is P-type, it is preferable to select a metal containing Be or Zn on a surface where the first electrode 54 contacts the first cladding layer 13 and a metal containing Si or Ge on a surface where the second electrode 56 contacts the second cladding layer 15 or the GaP window layer 16. When the first conductivity-type is N-type, it is preferable to select a metal containing Si or Ge on the surface where the first electrode 54 contacts the first cladding layer 13 and a metal containing Be or Zn on the surface where the second electrode 56 contacts the second cladding layer 15 or the GaP window layer 16. For example, N-type is selected as the first conductivity-type and P-type as the second conductivity-type, and then AuSi-based alloy can be used on the surface where the first electrode 54 contacts the first cladding layer 13, and AuBe-based alloy can be used on the surface where the second electrode 56 contacts the second cladding layer 15 or the GaP window layer 16.

In this embodiment, the first electrode 54 and the second electrode 56 can have a total thickness of about 0.5 µm each; however, any thickness can be selected as long as ohmic contact can be formed. In addition, the same effect can also be obtained by forming an additional metal layer, such as an Au or Al pad layer, or various Au-based bumps, on either or both the first electrode 54 and the second electrode 56.

Moreover, an additional pad layer can be separately provided on the second electrode 56 to align height with the first electrode 54. For example, when the second electrode 56 contacts the GaP window layer 16 and a step of approximately a few µm (e.g., 2.5 µm) is then generated between the first electrode 54 and the second electrode 56, a pad electrode made of Au, which has a thickness of a few µm (e.g., set to 2.5 µm) can be additionally produced to align the height.

In the micro-LED structure produced in this way, as shown in FIG. 11, the pattern of the micro-LED structure is pressed against a transfer substrate 70 made of quartz or the like, which has a silicone protruding pattern (silicone resin 65) being matched with a pattern and a pitch of the micro-LED structure (µ-LED dice). Subsequently, the excimer laser is irradiated from the transparent substrate 30 side, such as sapphire, onto the adhesive or the bonding material 25, such as BCB, to sublimate thereof. By sublimating the adhesive or the bonding material 25, such as BCB, the µ-LED dice are isolated from the transparent substrate 30, such as sapphire, thereby transferring the micro-LED dice from the transparent substrate 30, such as the sapphire substrate, to the transfer substrate 70 made of quartz or the like.

### (Second Embodiment)

Next, the second embodiment is described. This second embodiment is a case where an outer shape of a micro-LED structure in a plan view is rectangular.

In the second embodiment, as shown in FIG. 2**,** the outer shape of a light emitting device structure 18, which is device isolated, in the plan view is rectangular. Here, as shown in FIG. 2, it is assumed that a long-side direction B of the outer shape of the light emitting device structure 18, which is device isolated, in the plan view does not align with a direction A of a crystal orientation of <110>.

A method for producing this micro-LED structure is as follows. First, the step of producing a bonded substrate and a structure thereof (FIGS. 5 to 7) are the same as in the first embodiment.

The step of isolating a device (including the step of forming a SiO₂ pattern) (see FIG. 8) is also the same as in the first embodiment; however, the SiO₂ pattern shape is different from the first embodiment, being rectangular, not square. Here, as shown in FIG. 2, it is assumed that the long-side direction B of the outer shape of the light emitting device structure 18, which is device isolated, in the plan view does not align with the direction A of the crystal orientation of <110>. In particular, it is preferable that a direction of crystal orientation of <110> (direction A) is set to substantially align a line connecting a corner point and an opposite corner point with a <110> direction. The step (FIGS. 9 to 11) after the step of isolating a device (including the step of forming the SiO₂ pattern) is the same as in the first embodiment.

### (Third Embodiment)

Next, the third embodiment is described. This third embodiment is a case where an outer shape of a light emitting device structure 18, which is device isolated, in a plan view, as shown in FIG. 3, is rectangular having each side of substantially straight but corner points with curves (that is, corner points have an R). In other words, this third embodiment is a modified pattern of the second embodiment, where the corners of the rectangle do not have an angle of 90°. In this case, the long side is defined as the longest straight line. The shape in which the corner points can have the R is not limited to the rectangle; the same applies to the square shown in FIG. 1 or cases such as polygons shown in FIG. 4, described later. Here, as shown in FIG. 3, it is assumed that a long-side direction B of the outer shape of the light emitting device structure 18, which is device isolated, in the plan view does not align with a direction A of a crystal orientation of <110>.

A method for producing this micro-LED structure is as follows. First, the step of producing a bonded substrate and a structure thereof (FIGS. 5 to 7) are the same as in the first embodiment.

The step of isolating a device (including the step of forming a SiO₂ pattern) (see FIG. 8) is also the same as in the first embodiment; however, the SiO₂ pattern shape is different from the first embodiment, being rectangular having corner points with curves (that is, corner points have the R), not square. Here, as shown in FIG. 3, it is assumed that the long-side direction B of the outer shape of the light emitting device structure 18, which is device isolated, in the plan view does not align with the direction A of the crystal orientation of <110>. In particular, it is preferable that the direction of crystal orientation of <110> (direction A) is set to substantially align a line connecting a corner point and an opposite corner point with the <110> direction. The step (FIGS. 9 to 11) after the step of isolating a device (including the step of forming the SiO₂ pattern) is the same as in the first embodiment.

### (Fourth Embodiment)

Next, the fourth embodiment is described. This fourth embodiment is a case where an outer shape of a micro-LED structure in a plan view is polygonal.

In the fourth embodiment, as shown in FIG. 4, the outer shape of a light emitting device structure 18, which is device isolated, in the plan view is polygonal (hexagon in FIG. 4, but not a regular hexagon). Here, as shown in FIG. 4, it is assumed that a long-side direction B of the outer shape of the light emitting device structure 18, which is device isolated, in a plan view does not align with a direction A of a crystal orientation of <110>.

A method for producing this micro-LED structure is as follows. First, the step of producing a bonded substrate and a structure thereof (FIGS. 5 to 7) are the same as in the first embodiment.

The step of isolating a device (including the step of forming a SiO₂ pattern) (see FIG. 8) is also the same as in the first embodiment; however, the SiO₂ pattern shape is different from the first embodiment, being polygonal, not square. Here, as shown in FIG. 4, it is assumed that the long-side direction B of the outer shape of the light emitting device structure 18, which is device isolated, in the plan view does not align with the direction A of the crystal orientation of <110>. The step (FIGS. 9 to 11) after the step of isolating a device (including the step of forming the SiO₂ pattern) is the same as in the first embodiment.

### EXAMPLE

Hereinafter, the present invention will be described in detail with reference to Examples and Comparative Example. However, the present invention is not limited thereto.

### (Examples and Comparative Example)

In accordance with the second embodiment, a micro-LED structure 58 including a light emitting device structure 18 was produced. That is, as shown in FIG. 2, an outer shape of the light emitting device structure, which was device isolated, in a plan view was rectangular.

First, as shown in FIG. 5, an epitaxial wafer was provided with the light emitting device structure as an epitaxial functional layer. Specifically, the following was performed. First, after stacking an N-type GaAs buffer layer on an N-type GaAs starting substrate 11, an N-type GaₓIn₁₋ₓP (0.4≤x≤0.6) first etching stop layer having a thickness of 0.1 µm and an N-type GaAs second etching stop layer having a thickness of 0.1 µm were formed to produce an etching stop layer 12. An epitaxial wafer 20 was provided with the light emitting device structure 18 as the epitaxial functional layer, in which an N-type (Al_{y}Ga_{1-y})ₓIn₁₋ₓP (0.4≤x≤0.6, 0.6≤y≤1.0) first cladding layer 13 having a thickness of 1.0 µm, a non-doped (Al_{y}Ga_{1-y})ₓIn₁₋ₓP (0.4≤x≤0.6, 0≤y≤0.5) active layer 14, a P-type (Al_{y}Ga_{1-y})ₓIn₁₋ₓP (0.4≤x≤0.6, 0.6≤y≤1.0) second cladding layer 15 having a thickness of 1.0 µm, a P-type GaₓIn₁₋ₓP (0.5≤x≤1.0) intermediate layer (not shown) having a thickness of 0.1 µm, and a P-type GaP window layer 16 having a thickness of 6 µm were sequentially grown on the etching stop layer 12 (FIG. 5).

Next, as shown in FIG. 6, benzocyclobutene (BCB), being a thermosetting bonding member, was spin-coated as an adhesive or a bonding material 25 on the epitaxial wafer 20. A sapphire wafer, being a transparent substrate 30, was then stacked facing each other and bonded by thermocompression in a vacuum atmosphere. When BCB was coated by spin coating, a design thickness was set to 0.6 µm.

Next, as shown in FIG. 7, the GaAs starting substrate 11 was removed by wet etching to expose the N-type first etching stop layer, and the first and second etching stop layers were removed by etchants suitable for each to expose the first cladding layer 13. In this way, an epitaxial bonded substrate that retained only a DH layer and the window layer 16 was produced.

Next, a rectangular SiO₂ pattern, 50 µm long and 25 µm wide, was formed using a P-CVD, a photolithography method, and a wet etching method, and device isolation was then performed to form an island-shaped pattern. After forming the island-shaped pattern, a part of the DH layer portion was etched using the ICP method to expose the second cladding layer 15 (FIG. 8). Subsequently, a SiO₂ protective film 52 was formed on a processed cross section (FIG. 9). Then, as shown in FIGS. 2 and 10, a first electrode 54 and a second electrode 56, which had different polarities, were arranged near end portions in a long axis direction in a plan view. In this way, the micro-LED structure 58 was produced. In addition, a plurality of epitaxial bonded substrates were produced, and as the micro-LED structures 58 described above, the structures each having angles between a long-side direction B and a direction A of a crystal orientation of <110> being set to 0°(Comparative Example), 5°, 10°, 15°, 20°, 25°, 30°, 35°, 40°, and 45° (Examples) were produced.

As shown in FIG. 11, the micro-LED structures 58 produced in Examples and Comparative Example were transferred to a transfer substrate 70.

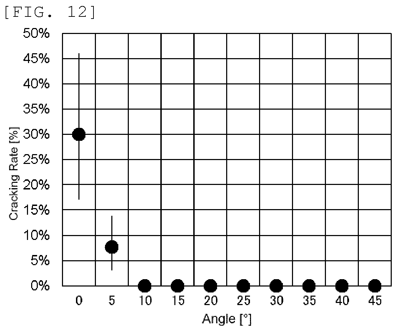

FIG. 12 shows the results of Examples and Comparative Example. In a case having a shape in which a long-side direction of an outer shape of the light emitting device structure in a plan view was substantially the same as a direction of the crystal orientation of <110>, i.e., Comparative Example, die cracking rate was around 30%, but by tilting the long-side direction described above from the crystal orientation of <110>, the cracking rate decreased and the cracking rate reached zero when the angle was set to 10° or more. Since the upper limit of the tilt angle from the crystal orientation of <110> is 45°, the upper limit of the tilt angle is 45°.

The present description includes the following embodiments.
[1]: A micro-LED structure comprising a light emitting device structure having an active layer composed of (Al_{y}Ga_{1-y})ₓIn₁₋ₓP (0.4≤x≤0.6, 0≤y≤0.5), the light emitting device structure being bonded to a transparent substrate transparent to both an emission wavelength and a laser light for LLO transfer by an adhesive that is transparent to the emission wavelength and absorbs the laser light for LLO transfer or a bonding material that is transparent to the emission wavelength and absorbs the laser light for LLO transfer, wherein
   the light emitting device structure is device isolated,
   the light emitting device structure, which is device isolated, has at least two electrodes of different polarities on one surface, and
   a long-side direction of an outer shape of the light emitting device structure, which is device isolated, in a plan view does not align with a crystal orientation of <110>.
[2]: The micro-LED structure according to the above [1], wherein
   the long-side direction of the outer shape of the light emitting device structure in the plan view is shifted in a range of 10° or more and 45° or less from the crystal orientation of <110>.
[3]: The micro-LED structure according to the above [2], wherein
   the long-side direction of the outer shape of the light emitting device structure in the plan view is shifted in a range of 22.5° or more and 30° or less from the crystal orientation of <110>.
[4]: The micro-LED structure according to any of the above [1] to [3], wherein
   the light emitting device structure does not have a starting substrate.
[5]: The micro-LED structure according to any of the above [1] to [4], wherein
   the adhesive or the bonding material is benzocyclobutene.
[6]: The micro-LED structure according to any of the above [1] to [5], wherein
   the transparent substrate is sapphire or quartz.
[7]: A method for producing a micro-LED structure, the method comprising the steps of:
   forming a light emitting device structure having an active layer composed of (Al_{y}Ga_{1-y})ₓIn₁₋ₓP (0.4≤x≤0.6, 0≤y≤0.5) on a starting substrate;
   bonding the light emitting device structure to a transparent substrate transparent to both an emission wavelength of the light emitting device structure and a laser light for LLO transfer by an adhesive that is transparent to the emission wavelength and absorbs the laser light for LLO transfer or a bonding material that is transparent to the emission wavelength and absorbs the laser light for LLO transfer;
   device isolating the light emitting device structure; and
   forming at least two electrodes of different polarities on one surface of the light emitting device structure, which is device isolated, wherein
   in the step of device isolating, a long-side direction of an outer shape of the light emitting device structure, which is device isolated, in a plan view does not align with a crystal orientation of <110>.
[8]: The method for producing a micro-LED structure according to the above [7], wherein
   the long-side direction of the outer shape of the light emitting device structure in the plan view is shifted in a range of 10° or more and 45° or less from the crystal orientation of <110>.
[9]: The method for producing a micro-LED structure according to the above [8], wherein
   the long-side direction of the outer shape of the light emitting device structure in the plan view is shifted in a range of 22.5° or more and 30° or less from the crystal orientation of <110>.
[10]: The method for producing a micro-LED structure according to any of the above [7] to [9], wherein
   the method further comprises the step of removing the starting substrate.
[11]: The method for producing a micro-LED structure according to any of the above [7] to [10], wherein
   the adhesive or the bonding material is benzocyclobutene.
[12]: The method for producing a micro-LED structure according to any of the above [7] to [11], wherein
   the transparent substrate is sapphire or quartz.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A micro-LED structure comprising a light emitting device structure having an active layer composed of (Al_{y}Ga_{1-y})ₓIn₁₋ₓP (0.4≤x≤0.6, 0≤y≤0.5), the light emitting device structure being bonded to a transparent substrate transparent to both an emission wavelength and a laser light for LLO transfer by an adhesive that is transparent to the emission wavelength and absorbs the laser light for LLO transfer or a bonding material that is transparent to the emission wavelength and absorbs the laser light for LLO transfer, wherein
the light emitting device structure is device isolated,
the light emitting device structure, which is device isolated, has at least two electrodes of different polarities on one surface, and
a long-side direction of an outer shape of the light emitting device structure, which is device isolated, in a plan view does not align with a crystal orientation of <110>.

2. The micro-LED structure according to claim 1, wherein
the long-side direction of the outer shape of the light emitting device structure in the plan view is shifted in a range of 10° or more and 45° or less from the crystal orientation of <110>.

3. The micro-LED structure according to claim 2, wherein
the long-side direction of the outer shape of the light emitting device structure in the plan view is shifted in a range of 22.5° or more and 30° or less from the crystal orientation of <110>.

4. The micro-LED structure according to claim 1 or 2, wherein
the light emitting device structure does not have a starting substrate.

5. The micro-LED structure according to claim 1 or 2, wherein
the adhesive or the bonding material is benzocyclobutene.

6. The micro-LED structure according to claim 1 or 2, wherein
the transparent substrate is sapphire or quartz.

7. A method for producing a micro-LED structure, the method comprising the steps of:
forming a light emitting device structure having an active layer composed of (Al_{y}Ga_{1-y})ₓIn₁₋ₓP (0.4≤x≤0.6, 0≤y≤0.5) on a starting substrate;
bonding the light emitting device structure to a transparent substrate transparent to both an emission wavelength of the light emitting device structure and a laser light for LLO transfer by an adhesive that is transparent to the emission wavelength and absorbs the laser light for LLO transfer or a bonding material that is transparent to the emission wavelength and absorbs the laser light for LLO transfer;
device isolating the light emitting device structure; and
forming at least two electrodes of different polarities on one surface of the light emitting device structure, which is device isolated, wherein
in the step of device isolating, a long-side direction of an outer shape of the light emitting device structure, which is device isolated, in a plan view does not align with a crystal orientation of <110>.

8. The method for producing a micro-LED structure according to claim 7, wherein
the long-side direction of the outer shape of the light emitting device structure in the plan view is shifted in a range of 10° or more and 45° or less from the crystal orientation of <110>.

9. The method for producing a micro-LED structure according to claim 8, wherein
the long-side direction of the outer shape of the light emitting device structure in the plan view is shifted in a range of 22.5° or more and 30° or less from the crystal orientation of <110>.

10. The method for producing a micro-LED structure according to claim 7 or 8, wherein
the method further comprises the step of removing the starting substrate.

11. The method for producing a micro-LED structure according to claim 7 or 8, wherein
the adhesive or the bonding material is benzocyclobutene.

12. The method for producing a micro-LED structure according to claim 7 or 8, wherein
the transparent substrate is sapphire or quartz.
